# EUROPEAN PATENT APPLICATION

(11) **EP 4 391 070 A1**
(43) Date of publication of application: **26.06.2024**
(21) Application number: 23855977.7
(22) Date of filing: 09.02.2023
(51) Int. Cl.: H01L 29/06, H01L 29/16, H01L 21/04

(54) **COMPOSITE SILICON CARBIDE SUBSTRATE AND PREPARATION METHOD THEREFOR**

(30) Priority: 25.08.2022 CN 202211022711
(71) Applicant: TJ Innovative Semiconductor Substrate Technology Co., Ltd., Tianjin 300451 (CN)
(72) Inventor: GUO, Chao, Tianjin 300451 (CN); MU, Fengwen, Tianjin 300451 (CN)
(74) Representative: Aseglio-Gianinet, Romina
(86) International application number: PCT/CN2023/075242
(87) International publication number: WO 2024/040880

(57) **Abstract**

Provided are a composite silicon carbide substrate and a preparation method therefor. The composite silicon carbide substrate comprises a single crystal layer, a bonding layer and a support layer which are stacked in sequence; a surface of the single crystal layer is provided with a periodic atomic step structure; the atomic step structure comprises any one of a four-width step structure, a two-width step structure or a single-width step structure. The preparation method comprises: (1) bonding a support layer with an ion-implanted single crystal substrate, and performing a heat treatment and detaching to obtain an intermediate product of the composite silicon carbide substrate; and (2) subjecting a surface of a single crystal layer of the intermediate product of the composite silicon carbide substrate obtained in step (1) to oxidation modification and polish removal alternately, that is, forming a periodic atomic step structure on the surface of the single crystal layer, to obtain the composite silicon carbide substrate. The composite silicon carbide substrate meets the needs of high-voltage power devices for silicon carbide epitaxial layers with a large thickness and high quality, and the preparation method is simple and efficient, and has good controllability.

## Description

### TECHNICAL FIELD

The present application belongs to the technical field of semiconductor materials, and relates to a composite silicon carbide substrate, and in particular to a composite silicon carbide substrate and a preparation method therefor.

### BACKGROUND

The devices based on monocrystalline silicon carbide have the advantages of high temperature resistance, high voltage resistance, high frequency, high power, radiation resistance and high efficiency, and have an important application value in the fields of radio frequency and new energy. The regular manufacturing process is to grow epitaxially a layer of high-quality monocrystalline silicon carbide on a monocrystalline silicon carbide substrate, then manufacture an electronic device such as a MOSFET on the epitaxial layer, and finally package the same to obtain a semiconductor device. The quality of the epitaxial layer has a crucial impact on the reliability of electronic devices. The researches show that the surface morphology of the monocrystalline silicon carbide substrate can directly affect the quality of the epitaxial layer growing thereon. For example, the warpage or TTV (Total Thickness Variation) of the monocrystalline silicon carbide substrate can cause an uneven temperature distribution on the growth surface of the epitaxial layer, resulting in lattice defects in the epitaxial layer; and the surface roughness, scratches left by polishing, and subsurface damage of the monocrystalline silicon carbide substrate can also affect the growth uniformity of the epitaxial layer, thus introducing defects into the epitaxial layer.

The prior art has strict requirements on the shape and surface quality of the monocrystalline silicon carbide substrate, and for example, TTV is generally less than or equal to 10 µm, and the surface roughness is less than or equal to 1 nm. However, as the silicon carbide power devices are developing towards the direction of high voltage, the thickness of the epitaxial layer is increasing. For example, when the voltage is about 600 V, the required thickness of the epitaxial layer is about 6 µm; when the voltage is increased to within 1200 V to 1700 V, the required thickness of the epitaxial layer is 10-15 µm; and when the voltage is more than 10000 V, the required thickness of the epitaxial layer may be more than or equal to 100 µm. The increasing thickness of the epitaxial layer in turn puts more and more stringent requirements on the surface quality of the monocrystalline silicon carbide substrate.

CN 103608899A discloses a substrate with a front surface and a back surface. At least one part of the front surface is composed of monocrystalline silicon carbide, and the substrate has: an average surface roughness Ra of the front surface of less than or equal to 0.5 nm, and a standard deviation σ of the surface roughness Ra of less than or equal to 0.2 nm; an average surface roughness Ra of the back surface of more than or equal to 0.3 nm and less than or equal to 10 nm, and a standard deviation σ of the surface roughness Ra of less than or equal to 3 nm; and a diameter of the front surface of more than or equal to 110 mm. Although the substrate can reduce the probability of defects caused in the step of forming an epitaxial film or semiconductor element to a certain extent, it is not suitable for the formation of epitaxial film with a large thickness, and the surface quality of the substrate needs to be further improved.

It can be seen that it is a very urgent problem to be solved for those skilled in the field how to provide a silicon carbide substrate and a preparation method therefor to meet the needs of high-voltage power devices for silicon carbide epitaxial layers with a large thickness and high quality.

### SUMMARY

The following is a summary of the subject described in detail herein. This summary is not intended to limit the protection scope of the claims.

An object of the present application is to provide a composite silicon carbide substrate and a preparation method therefor. The composite silicon carbide substrate meets the needs of high-voltage power devices for silicon carbide epitaxial layers with a large thickness and high quality, and the preparation method is simple and efficient, and has good controllability.

To achieve the object, the present application adopts the following technical solutions.

In a first aspect, the present application provides a composite silicon carbide substrate, and the composite silicon carbide substrate comprises a single crystal layer, a bonding layer and a support layer which are stacked in sequence.

A surface of the single crystal layer away from the bonding layer is provided with a periodic atomic step structure.

The atomic step structure comprises any one of a four-width step structure, a two-width step structure or a single-width step structure.

In the present application, the atomic step structure is arranged on the surface of the single crystal layer of the composite silicon carbide substrate to provide clear information about the crystal form for the growth of an epitaxial layer, realizing the growth of the epitaxial layer by a step-flow mode.

Specifically, there are dangling bonds on the step edge, and during the growth of the epitaxial layer, the atoms of gas source are prone to being bonded with the dangling bonds at the step edge, so that the atoms are constantly gathering at the step and moving breadthwise. In this way, the atomic stacking sequence of the substrate is transmitted to the epitaxial layer, and thus the epitaxial layer maintains a consistent crystal form.

In the present application, the atomic step structure shows a regular periodic change, and does not have surface amorphous layer or subsurface damage, which can achieve almost perfect step-flow growth, thereby minimizing the defects such as polytype phase transformation in the epitaxial layer, and meeting the needs of high-voltage power devices for silicon carbide epitaxial layers with a large thickness and high quality.

Preferably, step widths of the four-width step structure are periodically W1, W2, W3 and W4, and W1 < W3 < W2 < W4.

Preferably, step widths of the two-width step structure are periodically W5 and W6.

Preferably, step widths of the single-width step structure are periodically W7.

Preferably, the W1, W2, W3, W4, W5, W6 and W7 are each independently 0.06-0.11 nm, which can be, for example, 0.06 nm, 0.065 nm, 0.07 nm, 0.075 nm, 0.08 nm, 0.085 nm, 0.09 nm, 0.095 nm, 0.10 nm, 0.105 nm or 0.11 nm; however, the step widths are not limited to the listed values, and other unlisted values within this range are also applicable.

Preferably, the atomic step structure is arranged on a central area of the surface of the single crystal layer by an area proportion of more than or equal to 70%, which can be, for example, 70%, 72%, 74%, 76%, 78%, 80%, 82%, 84%, 86%, 88%, 90%, 92%, 94%, 96% or 98%; however, the area proportion is not limited to the listed values, and other unlisted values within this range are also applicable.

Preferably, an angle formed between the crystal plane (0001) of the single crystal layer and the surface of the single crystal layer is 2-8°, which can be, for example, 2°, 3°, 4°, 5°, 6°, 7° or 8°, and further preferably 4°; however, the angle is not limited to the listed values, and other unlisted values within this range are also applicable.

Preferably, the surface of the single crystal layer away from the bonding layer is also covered with an oxide layer, and a thickness of the oxide layer is less than or equal to 1.5 nm, which can be, for example, 0.2 nm, 0.4 nm, 0.6 nm, 0.8 nm, 1.0 nm, 1.2 nm, 1.4 nm or 1.5 nm; however, the thickness is not limited to the listed values, and other unlisted values within this range are also applicable.

In the present application, before the growth of the epitaxial layer, the composite silicon carbide substrate first needs to be etched to remove the oxide layer on the surface of the single crystal layer so as to expose the atomic-step structure.

Preferably, other area of the surface of the single crystal layer except the atomic step structure has a subsurface damage, and a depth of the subsurface damage is less than or equal to 1 nm, which can be, for example, 0.1 nm, 0.2 nm, 0.3 nm, 0.4 nm, 0.5 nm, 0.6 nm, 0.7 nm, 0.8 nm, 0.9 nm or 1 nm; however, the depth is not limited to the listed values, and other unlisted values within this range are also applicable.

In addition, more than or equal to 90% of the subsurface damage is located in an annular region at 2-5 nm distance from an edge of the single crystal layer.

Preferably, a thickness of the single crystal layer is 0.1-10 µm, which can be, for example, 0.1 µm, 1 µm, 2 µm, 3 µm, 4 µm, 5 µm, 6 µm, 7 µm, 8 µm, 9 µm or 10 µm; however, the thickness is not limited to the listed values, and other unlisted values within this range are also applicable.

Preferably, a thickness of the bonding layer is 1-5 nm, which can be, for example, 1 nm, 1.5 nm, 2 nm, 2.5 nm, 3 nm, 3.5 nm, 4 nm, 4.5 nm or 5 nm; however, the thickness is not limited to the listed values, and other unlisted values within this range are also applicable.

Preferably, a thickness of the support layer is 50-500 µm, which can be, for example, 50 µm, 100 µm, 150 µm, 200 µm, 250 µm, 300 µm, 350 µm, 400 µm, 450 µm or 500 µm; however, the thickness is not limited to the listed values, and other unlisted values within this range are also applicable.

In a second aspect, the present application provides a preparation method for the composite silicon carbide substrate according to the first aspect, and the preparation method comprises the following steps:
(1) bonding a support layer with an ion-implanted single crystal substrate, and performing a heat treatment and detaching to obtain an intermediate product of the composite silicon carbide substrate; and
(2) subjecting a surface of a single crystal layer of the intermediate product of the composite silicon carbide substrate obtained in step (1) to oxidation modification and polish removal alternately, that is, forming a periodic atomic step structure on the surface of the single crystal layer, to obtain the composite silicon carbide substrate.

Preferably, a specific form of the atomic step structure in step (2) is modulated by a ratio of a rate of the oxidation modification and a rate of the polish removal, and the modulation rule is as follows:
r = the rate of the oxidizing modification/the rate of the polish removal; when r is more than 1, the atomic step structure is a four-width step structure; when r is 1, the atomic step structure is a two-width step structure, and when r is less than 1, the atomic step structure is a single-width step structure.

The rate of the oxidation modification is specifically a thickness of silica film formed by the oxidation modification on the surface of the single crystal layer in unit time; and the rate of the polish removal is specifically a thickness of silica film removed by the polish removal on the surface of the single crystal layer in unit time.

Preferably, the rate of the oxidation modification and the rate of the polish removal are each independently 5-13 nm/min, which can be, for example, 5 nm/min, 6 nm/min, 7 nm/min, 8 nm/min, 9 nm/min, 10 nm/min, 11 nm/min, 12 nm/min or 13 nm/min; however, the rate is not limited to the listed values, and other unlisted values within this range are also applicable.

Preferably, the oxidation modification in step (2) comprises any one of the following methods:
(A) performing oxidation modification on the surface of the single crystal layer with an alkaline silica solution;
(B) performing oxidation modification on the surface of the single crystal layer by a Fenton reaction with a mixed solution of hydrogen peroxide and a ferrous salt; and
(C) performing oxidation modification on the surface of the single crystal layer with free radicals which are generated from water vapor and/or oxygen using a radio-frequency power supply.

A frequency of the radio-frequency power supply in step (C) is 10-15 MHz, which can be, for example, 10 MHz, 10.5 MHz, 11 MHz, 11.5 MHz, 12 MHz, 12.5 MHz, 13 MHz, 13.5 MHz, 14 MHz, 14.5 MHz or 15 MHz; however, the frequency is not limited to the listed values, and other unlisted values within this range are also applicable.

Preferably, the free radicals comprise hydroxyl radicals and/or oxygen radicals.

In the present application, the hydroxyl groups are generated by water vapor, and the oxygen radicals are generated by oxygen, so the specific type of the free radicals is determined by the specific composition of water vapor and/or oxygen, and the rate of oxidation modification of different free radicals is different. Generally speaking, the rate of oxidation modification of the oxygen radicals is lower than the rate of oxidation modification of the hydroxyl groups in the same environment, so the gas type can be selected according to the required oxidation modification rate.

Preferably, an abrasive material used in the polish removal comprises any one or a combination of at least two of silicon oxide, cerium oxide, iron oxide or zirconia, and a typical but non-limiting combination comprises a combination of silicon oxide and cerium oxide, a combination of cerium oxide and iron oxide, a combination of iron oxide and zirconia, a combination of silicon oxide, cerium oxide and iron oxide, a combination of cerium oxide, iron oxide and zirconia, or a combination of silicon oxide, cerium oxide, iron oxide and zirconia.

Preferably, a Mohs hardness of the abrasive material is 6-8, which can be, for example, 6, 6.2, 6.4, 6.6, 6.8, 7, 7.2, 7.4, 7.6, 7.8 or 8; however, the Mohs hardness is not limited to the listed values, and other unlisted values within this range are also applicable.

In the present application, the Mohs hardness of the abrasive material has a significant effect on the rate of the polish removal. Generally speaking, the abrasive material with a higher hardness leads to a higher rate of the polish removal, so the abrasive material with a corresponding hardness can be selected according to the required rate of the polish removal.

In addition, the rate of the polish removal is also affected by many factors such as a movement speed of the abrasive particles, a size of the abrasive particles, and a catalytic effect of the abrasive material.

Preferably, cleaning and drying are further performed in sequence after the polish removal.

Compared with the prior art, the present application has the following beneficial effects.
(1) In the present application, an atomic step structure is arranged on the surface of the single crystal layer of the composite silicon carbide substrate to provide clear information about the crystal form for the growth of the epitaxial layer, realizing the growth of the epitaxial layer by the step-flow mode.
(2) In the present application, the atomic step structure shows a regular periodic change, and does not have surface amorphous layer or subsurface damage, which can achieve almost perfect step-flow growth, thereby minimizing the defects such as polytype phase transformation in the epitaxial layer, and meeting the needs of high-voltage power devices for silicon carbide epitaxial layers with a large thickness and high quality.

After the accompanying drawings and detailed description are read and understood, other aspects can be understood.

### BRIEF DESCRIPTION OF DRAWINGS

Accompanying drawings are used to provide a further understanding of the technical solutions herein, form part of the specification, explain the technical solutions together with examples of the present application, and do not limit the technical solutions herein.
FIG. 1 is a structural schematic diagram of the composite silicon carbide substrate provided in the present application;
FIG. 2 is a microscopy image showing an atomic step structure on the composite silicon carbide substrate provided in the present application;
FIG. 3 is a schematic diagram of a four-width step structure on the composite silicon carbide substrate provided in the present application;
FIG. 4 is a schematic diagram of a two-width step structure on the composite silicon carbide substrate provided in the present application;
FIG. 5 is a schematic diagram of a single-width step structure on the composite silicon carbide substrate provided in the present application; and
FIG. 6 is a flow chart for preparing an intermediate product of the composite silicon carbide substrate in the preparation method provided in the present application.

Reference list: 1-single crystal layer; 2-support layer; 3-bonding layer; 100-single crystal substrate; 110-weakened layer; and 120-to-be-recovered layer.

### DETAILED DESCRIPTION

The technical solutions of the present application are further explained by the embodiments below. Those skilled in the field should understand that the examples merely assist in understanding the present application and should not be regarded as a specific limitation to the present application.

### Example 1

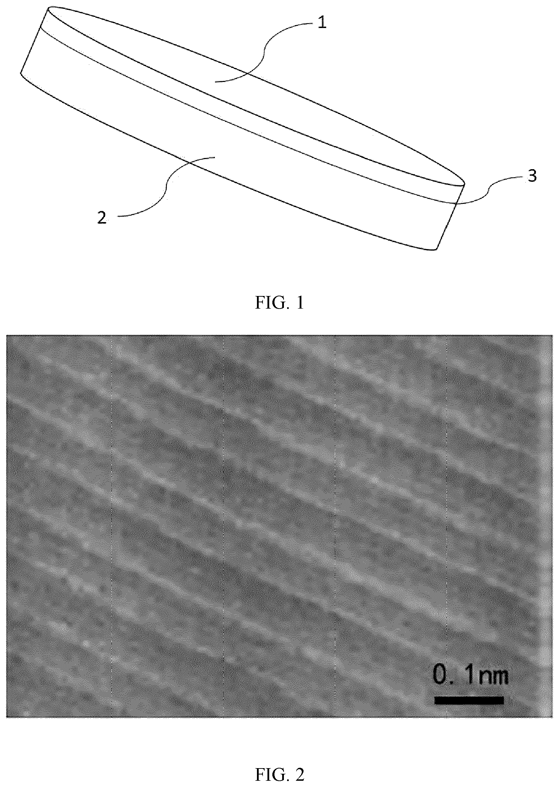

This example provides a composite silicon carbide substrate and a preparation method therefor. As shown in FIG. 1, the composite silicon carbide substrate comprises a single crystal layer 1, a bonding layer 3 and a support layer 2 which are stacked in sequence. A surface of the single crystal layer 1 away from the bonding layer 3 is provided with a periodic atomic step structure, and it can be seen from the microstructure shown in FIG. 2 that the atomic step structure does not have surface amorphous layer or subsurface damage.

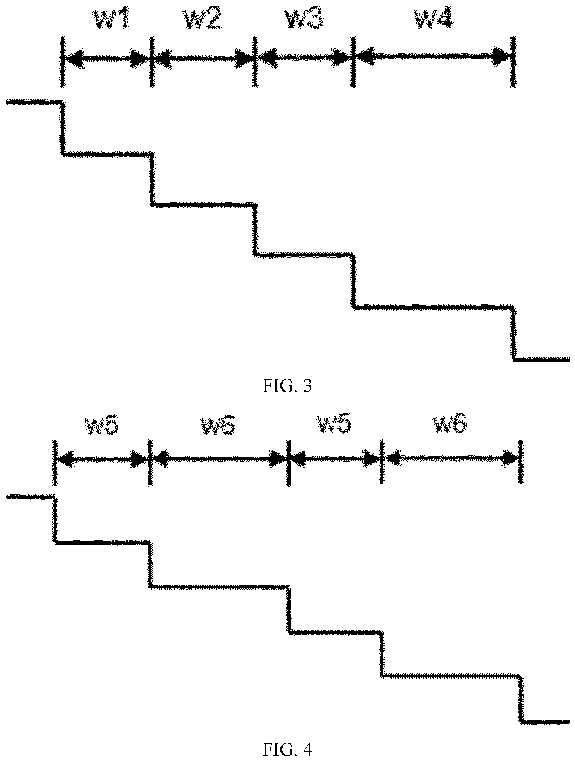

As shown in FIG. 3, the atomic step structure is specifically a four-width step structure, and step widths are periodically W1 of 0.06 nm, W2 of 0.073 nm, W3 of 0.068 nm and W4 of 0.11 nm. The atomic step structure is arranged on a central area of the surface of the single crystal layer 1 by an area proportion of 80%, although other area has a certain degree of subsurface damage, the subsurface damage has a maximum depth of 0.6 nm, and more than or equal to 90% of the subsurface damage is located in an annular region at 3 nm distance from the edge of the single crystal layer 1.

In this example, the single crystal layer 1 has an off-axis orientation, and specifically, an angle formed between the crystal plane (0001) of the single crystal layer 1 and the surface of the single crystal layer 1 is 4°. The surface of the single crystal layer 1 away from the bonding layer 3 is also covered with an oxide layer (Not shown in the figure), and a thickness of the oxide layer is 1.0 nm. A thickness of the single crystal layer 1 is 5 µm; a thickness of the bonding layer 3 is 3 nm; a thickness of the support layer 2 is 300 µm.

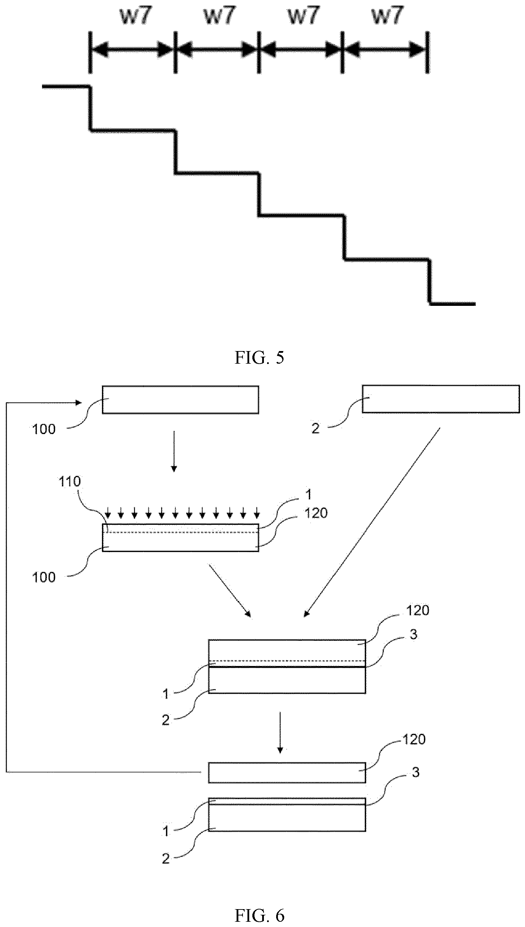

In this example, the preparation method comprises the following steps:
(1) a support layer 2 and an ion-implanted single crystal substrate 100 were bonded with each other, subjected to a heat treatment, and detached to obtain an intermediate product of the composite silicon carbide substrate, as shown in FIG. 6, specifically:
   (1.1) the single crystal substrate 100 was prepared, one surface of the single crystal substrate 100 was subjected to ion implantation with hydrogen ions, the ions were accelerated by an electric field to reach a position at a certain depth from the implantation surface, and combined with a silicon carbide material, so that the material at the position was weakened and thus formed an pre-buried weakened layer 110 at the certain depth from the surface, and the other part was a to-be-recovered layer 120;
   (1.2) the ion implantation surface of the single crystal substrate 100 obtained in step (1.1) and a surface of the support layer 2 were pressurized and bonded with each other to form a bonding layer 3 between the two layers; and
   (1.3) a composite substrate obtained in step (1.2) was subjected to a heat treatment, and the single crystal substrate 100 was gradually detached along the pre-buried weakened layer 110 to obtain the intermediate product of the composite silicon carbide substrate; and the to-be-recovered layer 120 that had been detached could be grinded and polished for reuse; and
(2) the surface of the single crystal layer 1 of the intermediate product of the composite silicon carbide substrate obtained in step (1) were alternately subjected to oxidation modification and polish removal to form a periodic atomic step structure on the surface of the single crystal layer 1, and after cleaning and drying processes, the composite silicon carbide substrate was obtained;
in step (2), the oxidation modification was specifically as follows: the surface of the single crystal layer 1 was subjected to the oxidation modification with hydroxyl free radicals having strong oxidizing activity which were produced from water vapor using a radio-frequency power supply, and a rate of the oxidation modification was 12.5 ± 0.5 nm/min; and the polish removal was specifically as follows: silicon oxide with a Mohs hardness of 7 was used as an abrasive material, a rate of the polish removal was set to 9.5 ± 0.5 nm/min by adjusting a rotation speed of the polishing disc, and finally a periodic four-width step structure was formed on the surface of the single crystal layer 1.

### Example 2

This example provides a composite silicon carbide substrate and a preparation method therefor. As shown in FIG. 1, the composite silicon carbide substrate comprises a single crystal layer 1, a bonding layer 3 and a support layer 2 which are stacked in sequence. A surface of the single crystal layer 1 away from the bonding layer 3 is provided with a periodic atomic step structure, and the atomic step structure does not have surface amorphous layer or subsurface damage.

As shown in FIG. 4, the atomic step structure is specifically a two-width step structure, and step widths are periodically W5 of 0.075 nm and W6 of 0.11 nm. The atomic step structure is arranged on a central area of the surface of the single crystal layer 1 by an area proportion of 85%, although other area has a certain degree of subsurface damage, the subsurface damage has a maximum depth of 0.7 nm, and more than or equal to 90% of the subsurface damage is located in an annular region at 2 nm distance from the edge of the single crystal layer 1.

In this example, the single crystal layer 1 has an off-axis orientation, and specifically, an angle formed between the crystal plane (0001) of the single crystal layer 1 and the surface of the single crystal layer 1 is 2°. The surface of the single crystal layer 1 away from the bonding layer 3 is also covered with an oxide layer (Not shown in the figure), and a thickness of the oxide layer is 1.2 nm. A thickness of the single crystal layer 1 is 0.1 µm; a thickness of the bonding layer 3 is 1 nm; a thickness of the support layer 2 is 50 µm.

In this example, the preparation method comprises the following steps:
(1) a support layer 2 and an ion-implanted single crystal substrate 100 were bonded with each other, subjected to a heat treatment, and detached to obtain an intermediate product of the composite silicon carbide substrate, as shown in FIG. 6, specifically:
   (1.1) the single crystal substrate 100 was prepared, a surface of the single crystal substrate 100 was subjected to ion implantation with hydrogen ions, the ions were accelerated by an electric field to reach a position at a certain depth from the implantation surface, and combined with a silicon carbide material, so that the material at the position was weakened and thus formed an pre-buried weakened layer 110 at the certain depth from the surface, and the other part was a to-be-recovered layer 120;
   (1.2) the ion implantation surface of the single crystal substrate 100 obtained in step (1.1) and a surface of the support layer 2 were pressurized and bonded with each other to form a bonding layer 3 between the two layers; and
   (1.3) a composite substrate obtained in step (1.2) was subjected to a heat treatment, and the single crystal substrate 100 was gradually detached along the pre-buried weakened layer 110 to obtain the intermediate product of the composite silicon carbide substrate; and the to-be-recovered layer 120 that had been detached could be grinded and polished for reuse; and
   (2) the surface of the single crystal layer 1 of the intermediate product of the composite silicon carbide substrate obtained in step (1) were alternately subjected to oxidation modification and polish removal to form a periodic atomic step structure on the surface of the single crystal layer 1, and after cleaning and drying processes, the composite silicon carbide substrate was obtained;
in step (2), the oxidation modification was specifically as follows: the surface of the single crystal layer 1 was subjected to the oxidation modification with hydroxyl free radicals having strong oxidizing activity which were produced from water vapor using a radio-frequency power supply, and a rate of the oxidation modification was 12.5 ± 0.5 nm/min; and the polish removal was specifically as follows: zirconia with a Mohs hardness of 8 was used as an abrasive material, a rate of the polish removal was set to 12.5 ± 0.5 nm/min by adjusting a rotation speed of the polishing disc, and finally a periodic two-width step structure was formed on the surface of the single crystal layer 1.

### Example 3

This example provides a composite silicon carbide substrate and a preparation method therefor. As shown in FIG. 1, the composite silicon carbide substrate comprises a single crystal layer 1, a bonding layer 3 and a support layer 2 which are stacked in sequence. A surface of the single crystal layer 1 away from the bonding layer 3 is provided with a periodic atomic step structure, and the atomic step structure does not have surface amorphous layer or subsurface damage.

As shown in FIG. 5, the atomic step structure is specifically a single-width step structure, and step widths are periodically W7 of 0.069 nm. The atomic step structure is arranged on a central area of the surface of the single crystal layer 1 by an area proportion of 70%, although other areas have a certain degree of subsurface damage, the subsurface damage has a maximum depth of 0.9 nm, and more than or equal to 90% of the subsurface damage is located in an annular region at 5 nm distance from the edge of the single crystal layer 1.

In this example, the single crystal layer 1 has an off-axis orientation, and specifically, an angle formed between the crystal plane (0001) of the single crystal layer 1 and the surface of the single crystal layer 1 is 8°. The surface of the single crystal layer 1 away from the bonding layer 3 is also covered with an oxide layer (Not shown in the figure), and a thickness of the oxide layer is 1.5 nm. A thickness of the single crystal layer 1 is 10 µm; a thickness of the bonding layer 3 is 5 nm; a thickness of the support layer 2 is 500 µm.

In this example, the preparation method comprises the following steps:
(1) a support layer 2 and an ion implanted single crystal substrate 100 were bonded with each other, subj ected to heat treatment, and detached to obtain an intermediate product of the composite silicon carbide substrate, as shown in FIG. 6, specifically:
   (1.1) the single crystal substrate 100 was prepared, a surface of the single crystal substrate 100 was subjected to ion implantation with hydrogen ions, the ions were accelerated by an electric field to reach a position at a certain depth from the implantation surface, and combined with a silicon carbide material, so that the material at the position was weakened and thus formed an pre-buried weakened layer 110 at the certain depth from the surface, and the other part was a to-be-recovered layer 120;
   (1.2) the ion implantation surface of the single crystal substrate 100 obtained in step (1.1) and a surface of the support layer 2 were pressurized and bonded with each other to form a bonding layer 3 between the two layers; and
   (1.3) a composite substrate obtained in step (1.2) was subjected to a heat treatment, and the single crystal substrate 100 was gradually detached along the pre-buried weakened layer 110 to obtain the intermediate product of the composite silicon carbide substrate; and the to-be-recovered layer 120 that had been detached could be grinded and polished for reuse; and
   (2) the surface of the single crystal layer 1 of the intermediate product of the composite silicon carbide substrate obtained in step (1) were alternately subjected to oxidation modification and polish removal to form a periodic atomic step structure on the surface of the single crystal layer 1, and after cleaning and drying processes, the composite silicon carbide substrate was obtained;
in step (2), the oxidation modification was specifically as follows: the surface of the single crystal layer 1 was subjected to the oxidation modification with hydroxyl free radicals having strong oxidizing activity which were produced from oxygen using a radio-frequency power supply, and a rate of the oxidation modification was 6.5 ± 0.5 nm/min; and the polish removal was specifically as follows: silicon oxide with a Mohs hardness of 7 was used as an abrasive material, a rate of the polish removal was set to 9.5 ± 0.5 nm/min by adjusting a rotation speed of the polishing disc, and finally a periodic single-width step structure was formed on the surface of the single crystal layer 1.

### Example 4

This example provides a composite silicon carbide substrate and a preparation method therefor. In the preparation method, the oxidation modification in step (2) was changed: a Fenton reaction was performed on the surface of the single crystal layer 1 with a mixed solution of hydrogen peroxide and ferrous sulfate, and a rate of the oxidation modification was set to 12.5 ± 0.5 nm/min by adjusting the solution concentration and the reaction temperature; the rest of steps and conditions are the same as in Example 1, which are not repeated here.

### Example 5

This example provides a composite silicon carbide substrate and a preparation method therefor. In the preparation method, the oxidation modification in step (2) was changed: the oxidation modification was performed on the surface of the single crystal layer with an alkaline silica solution, and a rate of the oxidation modification was set to 12.5 ± 0.5 nm/min by adjusting the pH and concentration of the solution; the rest of steps and conditions are the same as in Example 1, which are not repeated here.

### Comparative Example 1

This comparative example provides a composite silicon carbide substrate and a preparation method therefor. The composite silicon carbide substrate comprises a single crystal layer, a bonding layer and a support layer which are stacked in sequence. The surface of the single crystal layer away from the bonding layer is not provided with a periodic atomic step structure, but has a certain degree of subsurface damage, and the subsurface damage has a maximum depth of 1.2 nm and a proportion of area occupation of 50%.

In this comparative example, the single crystal layer has an off-axis orientation, specifically: an angle formed between the crystal plane (0001) of the single crystal layer 1 and the surface of the single crystal layer is 4°. The surface of the single crystal layer away from the bonding layer is also covered with an oxide layer, and a thickness of the oxide layer is 1.0 nm. A thickness of the single crystal layer is 5 µm; a thickness of the bonding layer is 3 nm; a thickness of the support layer is 300 µm.

In this comparative example, the preparation method comprises the following steps:
(1) a support layer and an ion-implanted single crystal substrate were bonded with each other, subj ected to heat treatment, and detached to obtain an intermediate product of the composite silicon carbide substrate, specifically:
   (1.1) the single crystal substrate was prepared, the surface of the single crystal substrate was subjected to ion implantation with hydrogen ions, the ions were accelerated by an electric field to reach a position at a certain depth from the implantation surface, and combined with a silicon carbide material, so that the material at the position was weakened and thus formed an pre-buried weakened layer at the certain depth from the surface, and the other part was a layer to be recovered;
   (1.2) the ion implantation surface of the single crystal substrate obtained in step (1.1) and the surface of the support layer were pressurized and bonded with each other to form a bonding layer between the two layers; and
   (1.3) a composite substrate obtained in step (1.2) was subjected to heat treatment, so that the single crystal substrate was gradually detached along the pre-buried weakened layer to obtain the intermediate product of the composite silicon carbide substrate; and a to-be-recovered layer that had been detached could be grinded and polished for reuse; and
(2) the surface of the single crystal layer of the intermediate product of the composite silicon carbide substrate obtained in step (1) were alternately subjected to polishing, cleaning and drying to obtain a composite silicon carbide substrate.

The composite silicon carbide substrate obtained from Examples 1-5 and Comparative Example 1 is used to grow the epitaxial layer, and the epitaxial layer is measured for the micropipe density and basal plane dislocation density to obtain curves showing the micropipe density and basal plane dislocation density varying with the thickness of the epitaxial layer. Generally speaking, as the thickness of the epitaxial layer is increased, the micropipe density and basal plane dislocation density are increased. The high-quality standard of the epitaxial layer is defined as having a microtubule density of less than 0.3/cm² and a basal plane dislocation density of less than 1000/cm², and a thickness range that the above high-quality standard required is defined as the "maximum thickness of high-quality epitaxial layer", and the relevant test results are shown in Table 1.

**Table 1**

| Composite silicon carbide substrate | Example 1 | Example 2 | Example 3 | Example 4 | Example 5 | Comparative Example 1 |
|---|---|---|---|---|---|---|
| Maximum thickness of high-quality epitaxial layer (µm) | 50.5 | 43.1 | 36.7 | 49.6 | 51.2 | 25.5 |

It can be seen from Table 1 that because its surface is not provided with a periodic atomic step structure, which is different from Examples 1-5, the composite silicon carbide substrate obtained in Comparative example 1 cannot achieve the growth of the silicon carbide epitaxial layer with a large thickness and high quality.

It can be seen that in the present application, an atomic step structure is arranged on the surface of the single crystal layer of the composite silicon carbide substrate to provide clear crystal-form information for the growth of the epitaxial layer, realizing the growth of the epitaxial layer by the step-flow mode; in addition, in the present application, the atomic step structure shows a regular periodic change, and does not have surface amorphous layer or subsurface damage, which can achieve almost perfect step-flow growth, thereby minimizing the defects such as polytype phase transformation in the epitaxial layer, and meeting the needs of high-voltage power devices for silicon carbide epitaxial layers with a large thickness and high quality.

The applicant declares that the above is only the embodiments of the present application, but the protection scope of the present application is not limited thereto. Those skilled in the field should understand that any change or replacement, which can be easily thought of by those skilled in the field within the technical scope disclosed in present application, shall fall within the protection scope and disclosure scope of the present application.

## Claims

1. A composite silicon carbide substrate, comprising a single crystal layer, a bonding layer and a support layer which are stacked in sequence;
a surface of the single crystal layer away from the bonding layer is provided with a periodic atomic step structure;
the atomic step structure comprises any one of a four-width step structure, a two-width step structure or a single-width step structure.

2. The composite silicon carbide substrate according to claim 1, wherein step widths of the four-width step structure are periodically W1, W2, W3 and W4, and W1 < W3 < W2 < W4;
step widths of the two-width step structure are periodically W5 and W6;
step widths of the single-width step structure are periodically W7;
the W1, W2, W3, W4, W5, W6 and W7 are each independently 0.06-0.11 nm.

3. The composite silicon carbide substrate according to claim 1, wherein the atomic step structure is arranged on a central area of the surface of the single crystal layer by an area proportion of more than or equal to 70%.

4. The composite silicon carbide substrate according to claim 1, wherein an angle formed between the crystal plane (0001) of the single crystal layer and the surface of the single crystal layer is 2-8°.

5. The composite silicon carbide substrate according to claim 1, wherein the surface of the single crystal layer away from the bonding layer is further covered with an oxide layer, and a thickness of the oxide layer is less than or equal to 1.5 nm;
other area on the surface of the single crystal layer except the atomic step structure has a subsurface damage, and a depth of the subsurface damage is less than or equal to 1 nm.

6. The composite silicon carbide substrate according to claim 1, wherein a thickness of the single crystal layer is 0.1-10 µm;
a thickness of the bonding layer is 1-5 nm;
a thickness of the support layer is 50-500 µm.

7. A preparation method for the composite silicon carbide substrate according to any one of claims 1-6, comprising the following steps:
(1) bonding a support layer with an ion-implanted single crystal substrate, and performing a heat treatment and detaching to obtain an intermediate product of the composite silicon carbide substrate; and
(2) subjecting a surface of a single crystal layer of the intermediate product of the composite silicon carbide substrate obtained in step (1) to oxidation modification and polish removal alternately, that is, forming a periodic atomic step structure on the surface of the single crystal layer, to obtain the composite silicon carbide substrate.

8. The preparation method according to claim 7, wherein a specific form of the atomic step structure in step (2) is modulated by a ratio of a rate of the oxidation modification and a rate of the polish removal, and the modulation rule is as follows:
r = the rate of the oxidation modification/the rate of the polish removal; in a case where r is more than 1, the atomic step structure is a four-width step structure; in a case where r is 1, the atomic step structure is a two-width step structure; and in a case where r is less than 1, the atomic step structure is a single-width step structure;
wherein the rate of the oxidation modification is specifically a thickness of silica film formed by the oxidation modification on the surface of the single crystal layer in unit time; and the rate of the polish removal is specifically a thickness of silica film removed by the polish removal on the surface of the single crystal layer in unit time;
the rate of the oxidation modification and the rate of the polish removal are each independently 5-13 nm/min.

9. The preparation method according to claim 7, wherein the oxidation modification in step (2) comprises any one of the following methods:
(A) performing oxidation modification on the surface of the single crystal layer with an alkaline silica solution;
(B) performing oxidation modification on the surface of the single crystal layer by a Fenton reaction with a mixed solution of hydrogen peroxide and a ferrous salt; and
(C) performing oxidation modification on the surface of the single crystal layer with free radicals which are generated from water vapor and/or oxygen using a radio-frequency power supply;
wherein a frequency of the radio-frequency power supply in step (C) is 10-15 MHz;
the free radicals comprise hydroxyl radicals and/or oxygen radicals.

10. The preparation method according to claim 7, wherein an abrasive material used in the polish removal comprises any one or a combination of at least two of silicon oxide, cerium oxide, iron oxide or zirconia;
a Mohs hardness of the abrasive material is 6-8;
cleaning and drying are further performed in sequence after the polish removal.
